**Europäisches Patentamt**

**European Patent Office**

**Office européen des brevets**

(19)

(11) Numéro de publication: **0 202 152**
**B1**

(12) **FASCICULE DE BREVET EUROPEEN**

(45) Date de publication du fascicule du brevet:
21.03.90

(51) Int. Cl.⁴: **H03B 9/14**

(21) Numéro de dépôt: 86400922.0

(22) Date de dépôt: 25.04.86

(54) Oscillateur hyperfréquences fonctionnant en bande millimétrique.

(30) Priorité: 15.05.85 FR 8507400

(43) Date de publication de la demande:
20.11.86 Bulletin 86/47

(45) Mention de la délivrance du brevet:
21.03.90 Bulletin 90/12

(84) Etats contractants désignés:
DE GB NL

(56) Documents cités:
EP-A- 0 053 945
FR-A- 2 463 538
US-A- 3 866 144
US-A- 4 008 446

ELCTRONICS LETTERS,
vol. 11, no. 17, 21 août 1975, pages 405–406; R.
KNÖCHEL et al.: "Design of cavity-stabilised
microwave oscillators"

(73) Titulaire: THOMSON-CSF, 51, Esplanade du Général de
Gaulle, F-92800 Puteaux(FR)

(72) Inventeur: Mamodaly, Narguise, THOMSON-CSF
SCPI 19, avenue de Messine, F-75008 Paris(FR)
Inventeur: Bert, Alain, THOMSON-CSF SCPI 19, avenue
de Messine, F-75008 Paris(FR)

(74) Mandataire: Taboureau, James et al, THOMSON-CSF
SCPI, F-92045 Paris La Défense Cédex 67(FR)

**Description**

La présente invention concerne un oscillateur en guide d'ondes, dont l'élément actif est un dispositif semiconducteur à résistance négative, tel qu'une diode Gunn ou Impatt. Cet oscillateur est destiné à fonctionner dans les fréquences dites millimétriques, c'est-à-diré dans la bande 30–300 GHz. Il est stabilisé par un résonateur diélectrique, couplé au guide d'ondes de telle façon que la cavité obtenue fonctionne en monomode. L'oscillateur selon l'invention est particulièrement stable en température, et peu bruyant.

La réalisation de sources de puissance en bande millimétrique – c'est-à-dire dont la longueur d'ondes est comprise entre 1 cm et 1 mm – ayant une bonne stabilité en fréquence et de bonnes caractéristiques de bruit ne peut être envisagée que sous la forme d'une source stable à diode Gunn ou Impatt. Les caractéristiques de stabilité et de bruit de la source de puissance sont celles de l'oscillateur synchronisateur. C'est donc un objet de l'invention que de proposer un oscillateur stable et peu bruyant.

On connait des oscillateurs extrêmement stables et peu bruyants, mais à de plus basses fréquences – bandes X, 6,2–10,9 GHz, et Ku 17,2–33 GHz – que celle concernée par l'oscillateur de l'invention: 94 GHz. Par exemple, le brevet US-A 3 866 144 décrit un oscillateur en guide d'ondes fonctionnant dans la bande 6 à 8,3 GHz. Selon une réalisation, le guide d'ondes est fermé à une extrémité et renferme, côte à côte selon l'axe principal, un résonateur diélectrique et une charge absorbante: les conditions sont étudiées pour que les fréquences autres que la fréquence de résonance soient totalement réfléchies. Cet oscillateur génère le mode fondamental et les modes harmoniques. Dans d'autres cas, les oscillateurs sont réalisés sur un substrat plan, supportant des lignes de propagation de type microbandes (microstrip lines), auxquelles sont couplés un ou plusieurs résonateurs diélectriques, qui se présentent comme des sphères, des cylindres ou des parallélépipèdes de rutile ou de grenat d'yttrium par exemple. Le coefficient de température du résonateur diélectrique peut être optimisé pour minimiser les variations de fréquence avec la variation de température. Par ailleurs, le coefficient de surtension $Q_{ext}$ est élevé, ce qui contribuera à améliorer le bruit de l'oscillateur.

Un oscillateur millimétrique stabilisé à 50 GHz par résonateur diélectrique a été décrit dans l'article "50 GHz IC Components Using Alumina Substrates" publié dans IEEE Trans. on Microwaves Theory and Techniques, vol. MTT 31, N°2, Fév. 83, pages 121 à 128. Mais le résonateur diélectrique est couplé à une ligne microbande.

Il semble que 50 GHz constitue une limite supérieure pour les oscillateurs plans sur substrats d'alumine, stabilisés par un résonateur diélectrique, et aucune publication ne décrit un oscillateur à résonateur fonctionnant au delà de 50 GHz.

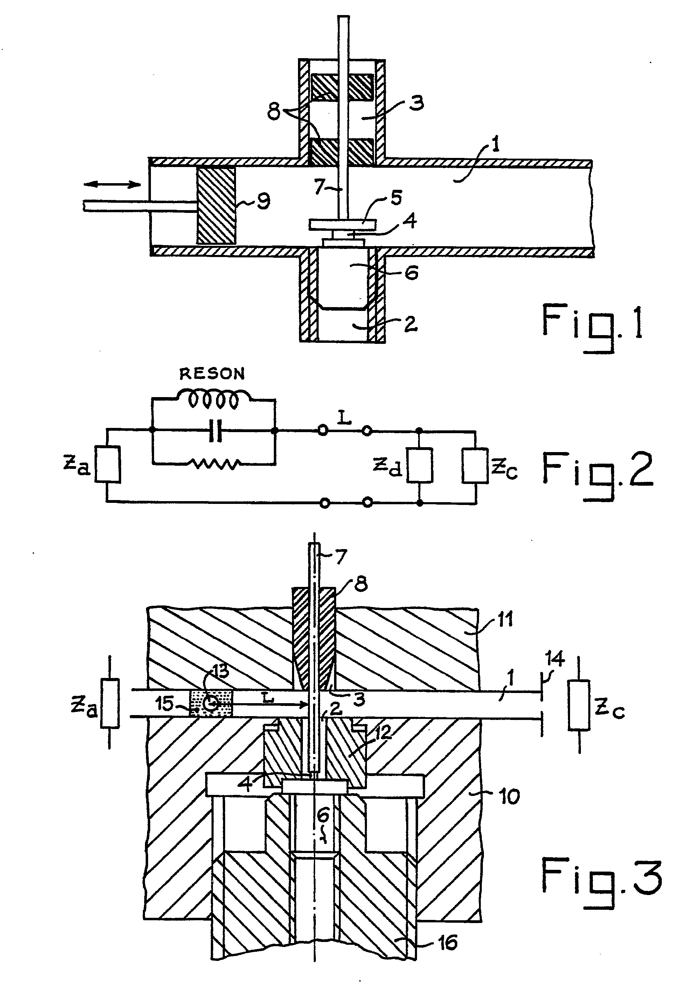

Les oscillateurs fonctionnant à de plus hautes fréquences sont jusqu'à présent réalisés en guide d'ondes, tel que celui qui est très schématiquement représenté en figure 1.

Un guide d'ondes 1 comporte un double Té 2 et 3, ces deux pièces étant en face à face. Le Té 2 permet de positionner dans le guide d'ondes une diode 4, montée et encapsulée sur une embase 6; un disque métallique résonant 5 sert d'adaptateur d'impédance: le diamètre de ce disque métallique est égal à λ/4. A travers le Té 3 passe une antenne 7 qui, s'appuyant sur la diode 4 par l'intermédiaire du disque 5, lui apporte une tension de polarisation. L'antenne 7 est maintenue et isolée au moyen d'une ou plusieurs charges absorbantes 8.

Cet oscillateur est réglé en fréquence au moyen d'un piston 9, qui peut être déplacé dans le guide d'ondes, et qui fait court-circuit pour les ondes. L'oscillateur selon l'invention a une cavité dont le fonctionnement est monomode. On utilise le double couplage de la diode et du guide, et du résonateur et du guide pour réaliser un oscillateur stable en fréquence et en température, peu bruyant et de plus compact.

De façon plus précise, l'oscillateur hyperfréquences, fonctionnant en bande millimétrique, comportant un guide d'ondes, dont une première extrémité, munie d'un iris, est chargée par une impédance de charge utile, et dont une deuxième extrémité, est chargée par une impédance de charge annexe, cet oscillateur comportant également un élément semiconducteur à résistance négative, électriquement polarisé au moyen d'une antenne qui couple l'élément semiconducteur au guide d'ondes, ainsi qu'un résonateur diélectrique, cet oscillateur étant caractérisé en ce que le résonateur diélectrique est placé dans le guide d'ondes entre l'antenne et la charge annexe à une distance de l'antenne telle que la cavité resonante délimitée par l'iris et le résonateur a un fonctionnement nonmode, par un double couplage de l'élément semiconducteur avec le guide d'ondes et du résonateur avec le guide d'ondes.

L'invention sera mieux comprise par la description plus détaillée qui en suit, faisant apparaître les avantages de cet oscillateur, et s'appuyant sur les figures jointes en annexe qaui représentent:

– figure 1: schéma simplifié d'un oscillateur connu en guide d'ondes, avec cavité radiale dite "à cap", exposée précédemment,
– figure 2: schéma électrique de l'oscillateur selon l'invention,
– figure 3: vue en coupe de la cavité résonante de l'oscillateur selon l'invention.

De façon à faciliter la description de l'invention, les mêmes indices de repère désignent les mêmes objets sur la figure 1 de l'art connu et sur la figure 3 représentant un oscillateur selon l'invention, dans la mesure où ces dits objets sont communs à l'art antérieur et à l'invention.

La figure 2 représente le schéma électrique de l'oscillateur à résonateur diélectrique. L'élément actif de cet oscillateur est une diode Gunn ou une diode Impatt, réalisée en matériaux du groupe III–V tels que par exemple GaAs ou InP, ou d'autres alliages ternaires ou quaternaires: elle a une impédance $Z_d$ ramenée dans le plan de couplage du guide d'ondes. Cette diode est introduite dans un guide d'onde, la cavité résonante étant définie par un iris (non représenté) du côté de la charge utile $Z_c$ et par un résonateur diélectrique, représenté par son schéma équivalent RLC en parallèle. Derrière le résonateur diélectrique se trouve une charge absorbante annexe $Z_a$.

Le résonateur diélectrique placé dans le guide d'ondes et de position réglable – ce qui fait varier la distance L résonateur-diode – est positionné de telle façon qu'à la fréquence de résonance il soit équivalent à une charge de coefficient de réflexion élevé; il réfléchit un maximum de puissance. La charge annexe $Z_a$, située dans le guide d'ondes du même côté que le résonateur par rapport à la diode, permet de s'assurer qu'en plus, en dehors de la résonance, les conditions d'oscillations ne sont pas remplies. Enfin, l'iris, situé entre la diode et la charge utile $Z_c$, peut être réalisé de différentes façons connues de l'homme de l'art : l'iris modifie l'impédance de sortie du guide d'ondes pour extraire le maximum de puissance, et il modifie la susceptance ramenée sur l'élément actif pour que la fréquence d'oscillation coïncide avec la fréquence propre du résonateur diélectrique.

Ainsi, pour cet oscillateur en bande millimétrique stabilisé par résonateur diélectrique, on utilise le couplage du résonateur utilisé en mode fondamental, avec le guide d'onde, et en outre le couplage magnétique de la diode au guide d'ondes. Un oscillateur en guide d'ondes peut être couplé soit sur le mode fondamental, soit sur un mode supérieur, selon le réglage effectué. Dans le cas présent, le résonateur est placé dans le guide d'ondes de telle sorte que son couplage avec le guide d'ondes corresponde au mode voulu, c'est-à-dire le mode fondamental.

Un tel système est équivalent à celui obtenu avec une cavité résonante métallique, mais l'oscillateur selon l'invention a l'avantage de fonctionner en monomode, tandis qu'un système à cavité résonante métallique, comportant donc un court-circuit à la place du système résonateur diélectrique plus charge annexe, fonctionne en multimode. De plus, le coefficient de surtension $Q_{ext}$ est plus élevé que celui obtenu conventionnellement avec une cavité à "cap" ce qui se traduit par une amélioration du bruit B.

La figure 3 représente une vue en coupe de la cavité résonante de l'oscillateur selon l'invention. Cette figure est simplifiée, et elle se limite à la seule région du système qui est proche de la diode et du résonateur, parce qu'en fait le guide d'onde et les charges utiles $Z_c$ et annexe $Z_a$ ont des dimensions qui ne sont pas compatibles avec cette figure, du moins à la même échelle.

L'exposé de cette figure permettra de mieux préciser par la suite quelques caractéristiques de l'oscillateur selon l'invention.

Un guide d'ondes 1 est formé entre deux blocs métalliques 10 et 11, en cuivre doré par exemple, l'un des deux blocs comportant une rainure usinée pour former le guide 1. Dans le bloc 10 est foré un orifice cylindrique 2 formant un Té avec le guide d'ondes 1, et dans le bloc 11 est foré un autre orifice cylindrique 3 formant un Té avec le guide, les deux orifices 2 et 3 étant alignés face à face, sur le même axe.

L'élément actif, c'est-à-dire la diode 4, montée et encapsulée sur une embase 6 puis vissée sur un dissipateur 16 est positionnée dans le bloc 10 à l'extrémité d'une tige coaxiale 7, qui amène sur la diode la tension de polarisation. La diode 4 étant séparée de l'axe du guide d'ondes 1 par une bague de transition 12, la tige métallique 7 sert d'antenne et se couple au champ magnétique du guide d'ondes. L'autre extrémité de cette antenne 7 comporte une charge absorbante 8.

Un résonateur diélectrique 13 est placé dans le guide d'ondes 1, entre le conducteur central ou antenne 7 et une charge annexe symbolisée par $Z_a$.

Un iris 14, introduit dans le guide d'ondes 1 entre le conducteur central 7 et la charge utile $Z_c$, optimise la puissance de sortie et modifie la susceptance ramenée sur l'élément actif, pour que sa fréquence d'oscillation coïncide avec la fréquence de résonance propre du résonateur diélectrique.

La diode 4 est bien entendu une diode capable d'osciller en hyperfréquences, au moins à 94 GHz dans le cas d'application envisagé, mais jusque 300 GHz de façon plus générale. C'est soit une diode Gunn en GaAs -ou autres matériaux assimilés tels que GaALAs- qui fonctionne en mode harmonique en bande millimétrique, soit une diode Gunn en InP, qui fonctionne en mode fondamental. Mais quel que soit le mode d'oscillation de la diode, le fonctionnement de la cavité délimitée par le résonateur diélectrique et l'iris est monomode.

Le résonateur diélectrique 13 est constitué par une sphère, un cylindre ou un parallélépipède d'un matériau diélectrique connu pour cet usage, tel que par exemple l'alumine $Al_2O_3$, le titanate de baryum $TiO_4Ba$ ou le titanate de zirconium et d'étain $(Zr, Sn)TiO_4$. Le résonateur, de dimensions plus petites que celles du guide d'ondes 1, est maintenu sur l'axe du guide au moyen d'une matière 15 ne présentant pas de pertes hyperfréquences.

A titre d'exemple non limitatif, à 94 GHz et pour un guide d'ondes ayant 2,54 mm d'épaisseur interne, un résonateur cylindrique 13 a un diamètre égal à 0,53 mm et une longueur comprise entre 0,29 et 0,32 mm.

Le résonateur est centré sur l'axe longitudinal du guide d'ondes 1. En effet, il ne doit pas être trop proche d'une paroi du guide d'ondes, sinon son coefficient de qualité se dégrade, ce qui signifie que la fréquence d'oscillation change et n'est plus accordée sur une fréquence précise, mais correspond plutôt à un spectre de fréquences.

Le résonateur diélectrique 13 est en outre plus proche de la diode, ou plus précisément de l'antenne 7, que ne l'est le court-circuit 9 dans un oscillateur selon l'art connu. Il s'ensuit que la dérive de fréquence en fonction de la température est plus faible que celle obtenue avec un oscillateur à cavité métallique déterminée par un court-circuit. En outre, cette dérive de fréquence, due en partie à la dilatation du guide d'ondes qui fait varier la longueur L résonateur-antenne, peut être compensée par le choix, pour le résonateur 13, d'un matériau diélectrique dont le coefficient de température annule ou au moins s'oppose à l'effet de dilatation du guide d'ondes.

Le titanate de zirconium et d'étain peut par exemple avoir un coefficient de température positif de 3 ppm/°C, ce qui permet une bonne stabilité de fréquence dans un intervalle de 60°C.

L'oscillateur hyperfréquence à résistance négative selon l'invention est utilisé dans les systèmes hyperfréquences nécessitant une certaine puissance obtenue à partir d'une pluralité de sources synchronisées par un oscillateur stable et n'ayant que peu de bruit. Il est en outre très compact. Il est appliqué dans des systèmes tels que les radars, les faisceaux hertziens, les télécommunications spatiales ou par fibres optiques.

## Revendications

1. Oscillateur hyperfréquences, fonctionnant en bande millimétrique, comportant un guide d'ondes (1), dont une première extrémité, munie d'un iris (14), est chargée par une impédance de charge utile ($Z_c$), et dont une deuxième extrémité est chargée par une impédance de charge annexe ($Z_a$) cet oscillateur comportant également un élément semiconducteur (4) à résistance négative, électriquement polarisé au moyen d'une antenne (7) qui couple l'élément semiconducteur (6) au guide d'ondes (1), ainsi qu'un résonateur diélectrique (13), cet oscillateur étant caractérisé en ce que le résonateur (13) est placé, dans le guide d'ondes (1), entre l'antenne (7) et la charge annexe ($Z_a$) à une distance (L) de l'antenne (7) telle que la cavité résonante délimitée par l'iris (14) et le résonateur (13) a un fonctionnement monomode, par un double couplage de l'élément semiconducteur (4) avec le guide d'ondes (1) et du résonateur (13) avec le guide d'ondes (1).

2. Oscillateur selon la revendication 1, caractérisé en ce que la charge annexe ($Z_a$) empêche l'oscillation en dehors des conditions de résonance dans le mode fondamental.

3. Oscillateur selon la revendication 1, caractérisé en ce que l'élément semiconducteur (4) à résistance négative est une diode hyperfréquences, de type Gunn ou de type Impatt.

4. Oscillateur selon la revendication 1, caractérisé en ce que le couplage du résonateur (13) avec le guide d'ondes (1) utilise le mode fondamental du résonateur (13).

5. Oscillateur selon la revendication 1, caractérisé en ce que le résonateur diélectrique (13) est en forme de sphère, de cylindre ou de parallélépipède.

6. Oscillateur selon la revendication 1, caractérisé en ce que le résonateur diélectrique (13) est maintenu en place, sur l'axe du guide d'ondes (1), au moyen d'une matière (15) ne présentant pas de pertes par absorption en hyperfréquences.

7. Oscillateur selon la revendication 1, caractérisé en ce que le résonateur diélectrique (13) est constitué d'un matériau tel que l'alumine, le titanate de baryum, le titanate double de zirconium et d'étain, ayant un coefficient de surtension élevé.

8. Oscillateur selon la revendication 7, caractérisé en ce que le matériau du résonateur diélectrique (13) est choisi de façon à compenser la dérive de fréquence avec la température.

9. Oscillateur selon la revendication 3, caractérisé en ce que l'iris (14) modifie la susceptance ramenée sur la diode (4) pour que la fréquence d'oscillation coïncide avec la fréquence de résonance propre du résonateur diélectrique (13).

## Claims

1. A microwave oscillator operating in the millimeter band, comprising a wave guide (1), of which a first end, provided with an iris diaphragm (14), is loaded by a working load impedance ($Z_c$) and of which a second end is loaded by an annexed load impedance ($Z_a$), said oscillator also comprising a semiconductor element (4) with a negative resistance and electrically biased by means of an antenna (7) which couples the semiconductor element (6) of the wave guide (1), and also dielectric resonator (13), said oscillator being characterized in that the resonator (13) is placed, in the wave guide (1), between the antenna (7) and the annexed load ($Z_a$) at a distance (L) from the antenna (7) such that the resonant cavity delimited by the iris diaphragm (14) and the resonator (13) has a monomode function, by a double coupling of the semiconductor element (4) with the wave guide (1) and the resonator (13) with the wave guide (1).

2. The oscillator as claimed in claim 1, characterized in that the annexed load ($Z_a$) prevents oscillation outside resonant states in the fundamental mode.

3. The oscillator as claimed in claim 1, characterized in that the semiconductor element (4) with negative resistance is a microwave diode of the Gunn or IMPATT type.

4. The oscillator as claimed in claim 1, characterized in that the coupling of the resonator (13) with the wave guide (1) utilizes the fundamental mode of the resonator (13).

5. The oscillator as claimed in claim 1, characterized in that the dielectric resonator (13) is in the form of a sphere, of a cylinder or of a parallelepiped.

6. The oscillator as claimed in claim 1, characterized in that the dielectric resonator (13) is maintained in position, on the axis of the wave guide (1), by means of a material (15) not exhibiting any absorption loss in the microwave range.

7. The oscillator as claimed in claim 1, characterized in that the dielectric resonator (13) is constituted by a material such as aluminum, barium titanate, zirconium tin titanate, having a high overvoltage coefficient.

8. The oscillator as claimed in claim 7, characterized in that the material of the dielectric resonator (13) is selected in such a manner as to compensate for frequency drift with changes in temperature.

9. The oscillator as claimed in claim 3, characterized in that the iris diaphragm (14) modifies the susceptance directed to the diode (4), so that the oscillation frequency coincides with the intrinsic resonant frequency of the dielectric resonator (13).

## Patentansprüche

1. Ultrahochfrequenz-Oszillator im Millimeterbandbetrieb, mit einem Wellenleiter (1), dessen erstes, mit einer Irisblende (14) ausgestattetes Ende mit einer Nutzlastimpedanz (Z_c) belastet ist und dessen zweites Ende mit einer Zusatzlastimpedanz (Z_a) belastet ist, wobei dieser Oszillator auch ein Halbleiterelement (4) mit Negativwiderstand umfaßt, das mittels einer Antenne (7) elektrisch polarisiert ist, die das Halbleiterelement (6) an den Wellenleiter (1) koppelt, sowie einen dielektrischen Resonator (13), wobei dieser Oszillator dadurch gekennzeichnet ist, daß der Resonator (13) im Wellenleiter (1) zwischen die Antenne (7) und die Zusatzlast (Z_a) in einem solchen Abstand (L) von der Antenne (7) liegt, daß der von der Irisblende (14) und dem Resonator (13) begrenzte Resonanzraum im Monomodenbetrieb ist, durch eine doppelte Kopplung des Halbleiterelements (4) mit dem Wellenleiter (1) und des Resonators (13) mit dem Wellenleiter (1).

2. Oszillator nach Anspruch 1, dadurch gekennzeichnet, daß die Zuastzlast (Z_a) die Schwingung außerhalb der Resonanzbedingungen in der Grundschwingungsform verhindert.

3. Oszillator nach Anspruch 1, dadurch gekennzeichnet, daß das Halbleiterelement (4) mit Negativwiderstand eine Ultrahochfrequenz-Diode vom Typ Gunn oder Typ Impatt ist.

4. Oszillator nach Anspruch 1, dadurch gekennzeichnet, daß die Kopplung des Resonators (13) mit dem Wellenleiter (1) den Grundtyp des Resonators (13) verwendet.

5. Oszillator nach Anspruch 1, dadurch gekennzeichnet, daß der dielektrische Resonator (13) kugel-, zylinder- oder quaderförmig ist.

6. Oszillator nach Anspruch 1, dadurch gekennzeichnet, daß der dielektrische Resonator (13) auf der Achse des Wellenleiters (1) mittels eines Materials (15) festgehalten wird, das keine Absorptionsverluste im Ultrahochfrequenzbetrieb aufweist.

7. Oszillator nach Anspruch 1, dadurch gekennzeichnet, daß der dielektrische Resonator (13) aus einem Werkstoff besteht, wie zum Beispiel Aluminiumoxid, Bariumtitanat, Zirkon-Doppeltitanat und Zinn, das einen hohen Gütefaktor hat.

8. Oszillator nach Anspruch 7, dadurch gekennzeichnet, daß der Werkstoff des dielektrischen Resonators (13) so gewählt wird, daß er die Frequenzdrift mit der Temperatur ausgleicht.

9. Oszillator nach Anspruch 3, dadurch gekennzeichnet, daß die Irisblende (14) die auf die Diode (4) zurückgeführte Suszeptanz abändert, damit die Schwingungsfrequenz mit der Eigenresonanzfrequenz des dielektrischen Resonators (13) zusammenfällt.

Fig.1

Fig.2

Fig.3